# EUROPEAN PATENT SPECIFICATION

(11) **EP 1 446 856 B1**
(45) Date of publication and mention of the grant of the patent: **28.04.2010**
(21) Application number: 02775157.7
(22) Date of filing: 19.11.2002
(51) Int. Cl.: H02J 13/00

(54) **METHOD AND SYSTEM FOR MONITORING ELECTRICAL APPLIANCES**
VERFAHREN UND VORRICHTUNG ZUR ÜBERWACHUNG DER ELEKTRISCHEN GERÄTE
PROCEDE ET SYSTEME DE SURVEILLANCE D'APPAREILS ELECTRIQUES

(30) Priority: 23.11.2001 IT AN20010050
(43) Date of publication of application: 18.08.2004
(73) Proprietor: Indesit Company S.p.A., 60044 Fabriano (AN) (IT)
(72) Inventor: FALCIONI, Paolo, I-60044 Fabriano (IT); MELONI, Francesca, I-60044 Fabriano (IT)
(74) Representative: Gallarotti, Franco
(86) International application number: PCT/IB2002/004851
(87) International publication number: WO 2003/044923

(56) References cited:
- WO-A-00/04427
- WO-A-01/15300
- WO-A-02/31944
- WO-A-02/41585
- WO-A-99/43068
- WO-A-02/056441
- US-A1- 2002 095 269
- SIMON M ET AL: "Modelling of the life cycle of products with data acquisition features" COMPUTERS IN INDUSTRY, ELSEVIER SCIENCE PUBLISHERS. AMSTERDAM, NL, vol. 45, no. 2, June 2001 (2001-06), pages 111-122, XP004245264 ISSN: 0166-3615
- SIMON M ET AL: "Life cycle data acquisition unit-design, implementation, economics and environmental benefits" PROCEEDINGS OF THE 2000 IEEE INTERNATIONAL SYMPOSIUM ON ELECTRONICS AND THE ENVIRONMENT (CAT. NO.00CH37082), PROCEEDINGS OF THE 2000 IEEE INTERNATIONAL SYMPOSIUM ON ELECTRONICS AND THE ENVIRONMENT. ISEE - 2000, SAN FRANCISCO, CA, USA, 8-10 MAY 2000, pages 284-289, XP002241469 2000, Piscataway, NJ, USA, IEEE, USA ISBN: 0-7803-5962-3

## Description

This invention refers to a method and a system for monitoring electrical appliances.

A system of the indicated type is described in WO-A-0 115 300, upon which the preamble of claims 1 and 14 is based, in accordance with which a monitoring device is contemplated, connected between a source of electric energy and the electrical appliance to be monitored.

The device includes means for measuring electrical quantities, such as power or current absorbed by the appliance for example, and a control system, programmed to compare the values of the measured electrical quantities with respective reference parameters or profiles, pre-recorded within the same control means.

In function of the aforesaid comparison, the device's control system is capable of generating various types of information regarding, for example, the electrical appliance, its state of efficiency, the manner in which it is used over time, its consumption of electric energy, the identification of the operational phase in course on the appliance itself. In this way, by the association of the monitoring device with an electrical appliance, the possibility is offered of efficiently identifying and/or signalling the nature of a malfunction as soon as it occurs, and of detecting the initial symptoms of an anomaly in the operation of the appliance itself even before this becomes a problem for the user; likewise, the monitoring device allows the conditions and manner of usage of the appliance over time to be detected, for the purpose of estimating with sufficient accuracy the state of wear on its internal components; for this purpose, the monitoring device can be set up to transmit certain information that it generates and/or stores to an external centre, for the purpose of permitting remote support, also of the "preventive" type, for the relative electrical appliance.

The device of the aforesaid document is, in a certain measure, of a dedicated type as it assumes the presence, inside the memory means forming part of its control system, of a multitude of reference profiles, each of which is relative to a given type of electrical appliance and is representative of the normal operation of the latter; these reference profiles are determined in advance via experimental analysis, and are then recorded in the control system of the monitoring device during the production phase of the latter.

At the moment of installation, the monitoring device is manually set up, via *dip-switches* for example, according to the specific electrical appliance associated with it; in this way, the control system of the device can identify, from the multitude of reference profiles recorded in it, the one(s) to be used for monitoring the correct operation of the associated electrical appliance and therefore to generate the various types of information relative to its mode of utilization.

In order to permit a multitude of reference profiles to be recorded, this type of approach, however efficient, assumes the recording of a large quantity of data, and consequently a high memory capacity for the control system of the device; however, even with the availability of high-capacity memory, it is quite difficult that this could contain the reference profiles for all of the possible types of electrical appliance that the device is suitable for being associated with.

This invention proposes, first of all, to resolve the aforesaid drawback, as well as realizing additional functional optimisations of a monitoring system of the type described in WO-A-0 115 300.

This and other aims as well, as will become clear in the following, are achieved in accordance with this invention by a method and a system for monitoring electrical appliances possessing the characteristics defined in the enclosed claims, which are intended to be an integral part of this description.

Further aims, characteristics and advantages of the invention will become evident from the description that follows, with reference to the enclosed drawings, supplied purely by way of a non-limitative example, and where:
- Figure 1 is a schematic view aimed at illustrating the method of connection between a monitoring device and a generic electrical appliance,
- Figure 2 is a block diagram of a possible physical embodiment of the monitoring device shown in Figure 1,
- Figure 3 is a simplified layout of a possible architecture for the monitoring system in accordance this invention.

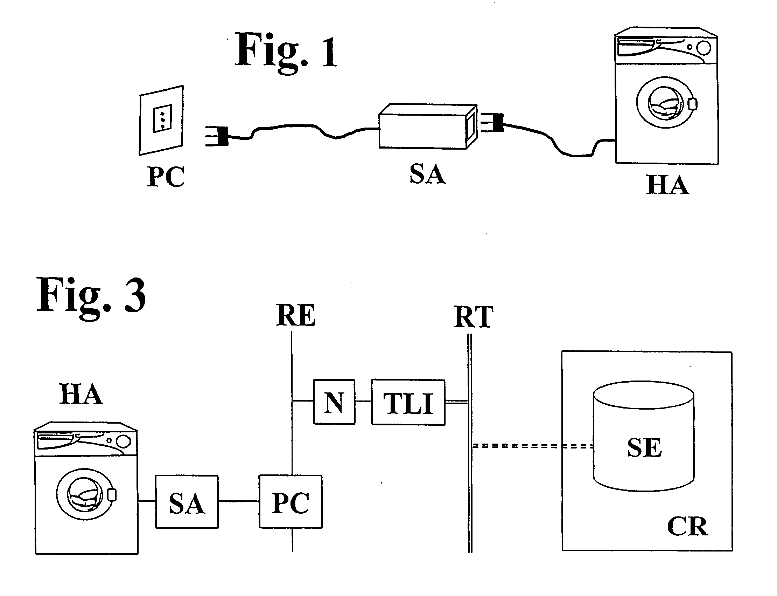

Figure 1 illustrates the method of connection between a monitoring device SA and a generic electrical appliance HA, represented in this specific case by a washing machine.

The device SA, which is placed between the electric socket, indicated as PC, and the electrical appliance HA, is of the type envisaged for performing the monitoring and control functions on the electrical appliance HA in question.

According to the application of the invention described herein, the basic functions carried out by the monitoring device SA are one or more of the following:
- measurement, instant by instant, of the electric current absorbed by the appliance HA,
- measurement of the mains voltage applied to the appliance HA,
- measurement of the power factor (cosφ) of the electrical load represented by the appliance HA,
- measurement, instant by instant, of the power absorbed by the appliance HA,
- measurement, and storage in a non-volatile memory, of the electric energy consumed by the appliance HA,
- control, also remote, of the appliance HA via a relay,
- generation, and storage in a non-volatile memory, of information relative to the operating state of the appliance HA,
- generation, and storage in a non-volatile memory, of statistical data relative to the operation of the appliance HA and the manner in which it is used by the owner or user,
- generation, and storage in a non-volatile memory, of diagnostic information relative to the operation of the appliance HA, obtained on the basis of trends in the electrical quantities measured by the same device SA,
- capacity of dialogue with the outside world, achieved via the utilization of opportune communications technologies (carrier frequency transmission, radio frequency, twisted pair, etc.).

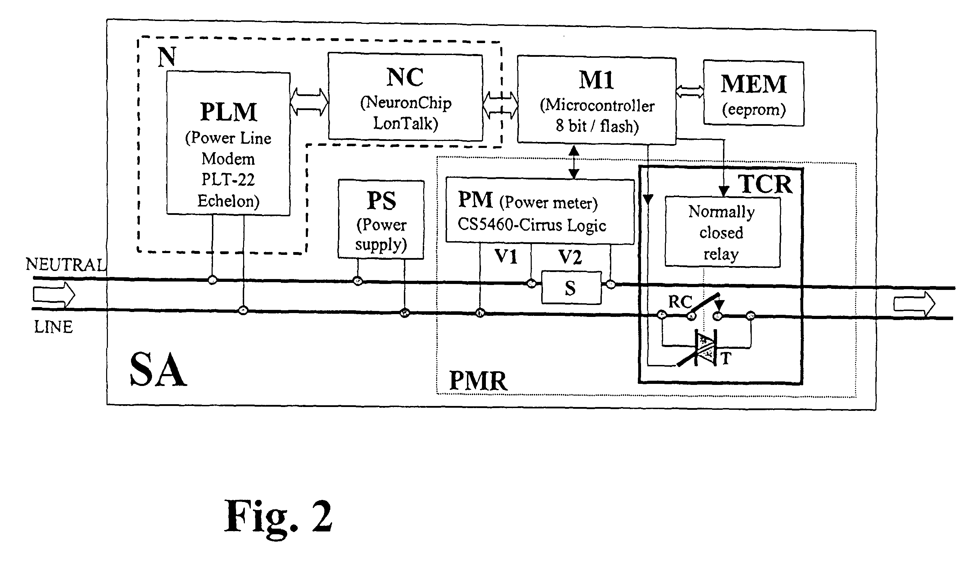

A possible physical embodiment of the device SA, to be intended purely as a non-limitative example, is shown in Figure 2.

In this figure, the block PLM (Power Line Modem) represents a *transceiver,* of the Echelon PLT-22 type for example, the aim of which is to provide bi-directional communications via carrier frequency transmission to the outside world, via a suitable communications protocol, such as LonTalk^{®} (ANSI EIA-709). This protocol is implemented inside the block indicated as NC, composed of a NeuronChip^{®} device for example, currently produced by Toshiba and Cypress.

The set of blocks PLM and NC thus constitute the so-called *communications node,* represented in Figure 2 by the dashed block N.

The block indicated as M1 (Micro-controller) is constituted by any 8-bit micro-controller, preferably but not necessarily equipped with *flash* memory, the purpose of which is that of supervising the control of the monitoring device SA.

The block indicated as PS (Power Supply) represents a circuit, of known type, for providing a stabilized supply to all components of the device SA, in accordance with their electrical specifications.

The block indicated as MEM represents the memory means, composed of a non-volatile EEPROM memory for example, opportunely connected to the micro-controller M1, in which the latter records the information acquired from studying the trends of one or more electrical quantities associated with the operation of the electrical appliance HA, detected via a measuring block, indicated as PM (Power Meter).

The PM block has the important task of measuring one or more of the various electrical quantities associated with the operation of the electrical appliance HA and of communicating the measured value to the micro-controller M1, to which it is opportunely connected. The PM block can be realized, for example, via a CS5460 device from Cirrus Logic, capable of taking measurements of current, voltage, power factors (cosφ), power and energy.

For the purposes of operation of the device SA, the precise measurement of power (derived quantity) can be replaced by a simple current (primary quantity) measurement if necessary; therefore, in a more simple and economic form of embodiment, the PM block could be entirely composed of a current sensor, a *shunt* resistance or a toroid for example, the generated voltage of which is proportional to the current absorbed by the electrical appliance and is read (directly or after opportune amplification) by the micro-controller M1 through an opportune analogue-digital conversion channel.

In the case of the device PM illustrated in Figure 2, the measurement of primary electrical quantities, represented as is known by the current absorbed by the electrical appliance HA and the voltage applied to its terminals, is performed by respectively measuring the voltage V2, detected on the terminals of a suitable resistive current sensor (shunt resistance, or toroid, or other current detector), indicated by the block S (Shunt), and the voltage V1, detected via a suitable resistive divider, not shown as it is contained within the PM block itself. In a possible variant, intended for monitoring a three-phase appliance, the measuring part is replicated three times, one for each phase, while the processing can be performed by a single microprocessor.

The derived electrical quantities, such as cosφ, power and energy, are obtained via opportune mathematical calculations, effected by the same CS5460 device in the PM block, or directly by the micro-controller in cases where a measurement device other than the aforesaid CS5460 is used. In any case, the measurements are made available to the micro-controller M1 for possible further processing.

Always referring to Figure 2, TCR indicates a block comprising a triac T and a relay RC with a normally-closed mobile contact, the purpose of which is to force, in cases of necessity and under command from the micro-controller M1, an interruption of the electric power supply to the appliance HA; this is an ON/OFF type of activity, performed by the TCR block with respect to the relative electrical appliance, that can be carried out within the realm of an adjustment process for the absorption of electrical power in the domestic environment. The SA device can also be programmed to disconnect the appliance HA, by opening the relay, when certain significant fault conditions are encountered.

From an analysis of the profile of the various electrical quantities, performed by the micro-controller M1 interpreting or processing the measurements taken by the sensor PM, it is possible to monitor the operation of the appliance HA, to identify the number and type of work cycles that it has performed, both instantaneously and day by day, and to detect any operating anomalies.

This is achieved by comparing, via suitable software inside the micro-controller M1, the values of the detected electrical quantities with the respective reference parameters or profiles, indicated in the following as *"patterns"* and representative of the normal operating conditions of the electrical appliance HA, contained in the memory of the micro-controller M1 itself or in a special area of the memory means MEM; therefore, from this viewpoint, the operation of the device SA is of the type described in WO-A-0 115 300.

The various types of information generated by the device SA are successively made available outside the device itself, using any known technique, for example, via indicators integrated into the device itself (e.g. luminous indicators or buzzers), or via means of display associated with the RE and/or RT communications networks.

In accordance with an important aspect of this invention, the aforesaid reference patterns are not constituted by data pre-recorded on the control system of the device SA during the production phase of the latter, but the fruit of readings taken by the device itself, opportunely processed and encoded by means of a remote expert system.

To make this aspect clearer, Figure 3 schematically illustrates a possible architecture for the monitoring system in accordance with this invention.

In this figure, the reference numbers of the previous figures are used in part; thus, SA indicates a monitoring device, which is inserted on the power line between a generic appliance HA and an electric socket PC, the latter being connected to the electricity grid, indicated as RE, of the environment in which the appliance HA is installed.

RT indicates the telephone system, which serves the same environment in which the appliance HA is installed. TLI (*Telephone Line* Interface) indicates the interface with the telephone system RT, realized in the known manner; the TLI interface is connected to the electricity grid RE via a respective communications node, similar to that indicated as N in Figure 2.

CR indicates a remote centre, in which an expert system is implemented, indicated as SE; the expert system SE can be of the inferential engine type, implemented using any known technology, via *fuzzy logic* or neural networks for example.

Through its own communications node N(see Figure 2), the device SA is capable of transmitting the information it generates over the electricity grid RE, using the carrier frequency transmission system, for the benefit of the TLI interface, also connected to the grid RE via its own communications node N; the TLI interface is then, in turn, operative for transferring the information received from the device SA to the remote centre CR, using the telephone system RT. Given that the contemplated communication between the device SA and the centre CR is bi-directional, the former is also subject to receiving information or instructions from the latter.

On this basis and in accordance with the invention, at least two distinct phases of system operation are contemplated, more precisely, a learning phase and a monitoring phase.

The learning phase begins when the device SA is installed in combination with the relative electrical appliance HA.

In this phase, the device SA functions simply as an "acquirer" of data, or rather, as previously explained, it takes the measurements of the various electrical quantities that are involved in the operation of the appliance HA.

In the learning phase, which is realized in the first weeks of using the device SA in combination with the appliance HA, the above mentioned reference patterns are not present in the control system of the device itself (or more precisely, the settings of the parameters for these patterns will have non-representative values, such as zero for example, and as such, are not immediately utilizable for generating the various types of information that the device SA is responsible for).

In fact, the device SA thus limits itself to reading the various electrical quantities and storing them in its memory MEM, and then periodically sending them to the remote centre CR. In the preferred embodiment of the invention, the micro-controller M1 is programmed to perform an anticipatory compression of data regarding the values of the aforesaid electrical quantities before storing them; this allows the storage capacity of the device SA to be exploited to the maximum, whilst also reducing data transmissions to the remote centre CR.

In the first weeks of operation of the appliance HA, the data that is subsequently received in compressed form by the expert system SE at the remote centre CR is used for learning the typical operation of the latter and so generate the reference patterns specific to that appliance.

For this purpose, the moment that the device SA is installed, it will be "registered" at the centre CR, to inform the expert system SE in advance of the type of appliance HA. From this viewpoint, for example, the installer of the device SA needs only to register the activation of the device SA on a special Internet site, or send a message or phone to personnel at the centre CR, informing the latter that the device SA, identified by a certain code, is paired with a washing machine, for example. This information will be registered on the expert system SE that, in a known manner, will then be in the situation of knowing that the data packets received with that specific code are the result of readings taken on a washing machine.

Please note that, in general terms, the expert system SE could be programmed, using *clustering* techniques, to automatically recognize the "family" of an electrical appliance associated with a device SA; the prevision for a "manual" registration or identification of the type of appliance, in the aforesaid manner, does however simplify the processing logic of the expert system SE, avoiding an excessive overloading of its structure.

Considering that the electrical loads typical of certain families of electrical appliances are always the same (for example, a washing machine will always have a discharge pump, a heating resistance, a detergent dispenser, etc., in the same way that a refrigerator will always have a compressor, a defrost resistance, a light for illumination, etc.), the expert system SE will be implemented to automatically recognise the various electrical loads of the appliance HA, via extrapolation techniques of characteristic quantities, *clustering* and classification of values of the electrical quantities as they are measured and sent by device SA. The expert system SE will be equipped with a knowledge base on the malfunctions and characteristics of the electromechanical components and, as said, its inferential engine can be of the fuzzy logic type or implemented via a neural network. During its operation, the expert system SE associates the clusters found with the various electromechanical components present in a family of appliances, by exploiting general rules programmed into the same expert system SE in the known manner.

During the course of the first weeks of work of the device SA, the expert system SE will thus take care of collecting the data arriving from the device SA and processing it, with the aim, in substance, of obtaining average or maximum or minimum values of the various quantities, which constitute the aforesaid reference patterns; as said, these reference patterns express the conditions of normal operation for the various electrical loads of the appliance HA and will then be used by the device SA to achieve its information generation functions.

It should be underlined here that the specified methods via which the generation of this information is realized are beyond the objectives of this invention and, as they can be implemented using any known technique, they will not be described in detail herein. Here it is sufficient to remember that, for example, in general terms, the diagnostic capabilities of the device SA are based on the possibility of identifying the switching on and off of the various electrical loads of the appliance HA and recognizing the respective times of operation. As already mentioned, these loads can be automatically classified and recognized by the device SA, based upon the electrical characteristics that distinguish them (power, voltage-current phase difference and average switch-on time for example), or rather the "electrical signature", which can be translated into a point in space.

When a load operates in an anomalous manner, its electrical signature remains recognizable, but shifted with respect to its normal zone of operation, where the manner of the shift depends on the type and entity of a malfunction: thus, via the analysis of the variance with respect to the normal position of the electrical signature, the device SA is capable of identifying the malfunction of the respective electrical load.

Please note that the device SA employed in the system in accordance with the invention, in addition to evaluating variances of reference parameters or patterns, is programmed to detect anomalies relative to an erroneous sequence in the operating phases of the appliance HA.

When the expert system SE has taken care of determining the aforesaid reference patterns specific to the appliance HA, these are transmitted by the same system to the device SA for storing thereon, in an area of the memory means MEM, for example.

The learning phase of the system is thus terminated and the device SA ceases to be a simple detector of electrical quantities, to assume the role of an autonomous monitoring and control device. Thus, in this phase, the electrical quantities measured by the device SA are compared with the reference patterns recorded therein, for the purposes of generating the various types of information, as previously identified.

Thus, as can be seen, thanks to its learning capacity, the monitoring system in accordance with the invention is capable of operating independently of the firm and model of the electrical appliance.

In accordance with an important aspect of this invention, the microprocessor M1 of the device SA is programmed to perform, from the moment of installation, measurements for possible power supply *overvoltages* and *brownouts* within a certain detection period. Any voltage fluctuations in the power supply feeding the appliance HA can cause unreliable readings for the electrical quantities measured by the device SA, or rather values that do not represent neither anomalies in appliance operation, nor normal operating conditions for the appliance.

According to the invention, therefore, the information representing these power supply voltage fluctuations is recorded in a non-volatile memory of the device SA, both for allowing the latter to realize extremely accurate monitoring of the appliance HA and for avoiding that the creation of the reference patterns, generated by the expert system SE, becomes partially falsified; for this reason therefore, the device SA also takes care of transmitting information regarding power supply voltage fluctuations to the expert system SE, together with the data relative to the various electrical quantities measured.

In this way, during the usual monitoring activity performed by the device SA, the latter will be able to "correct" the measurement of the electrical quantities detected on occasion of the possible voltage fluctuations, in order to avoid the appliance malfunction signals, which do not really exist.

In this way, during the system's learning phase, the availability of information regarding the possible presence of power supply voltage fluctuations will permit the expert system to avoid calculating reference patterns for the appliance HA falsified at source by the said voltage fluctuations.

In accordance with a possible embodiment of the invention, the system could be conceived such that the device SA continues with the periodic transmission of data to the remote centre CR, even after the termination of the learning phase; such a possibility could be provided in the case where high-level diagnostic checks on the appliance HA are entrusted to the expert system SE, which disposes of storage and processing capacities unquestionably superior to those of the device SA.

From this viewpoint, for example, the inferential engine of the expert system SE could be entrusted with the direct detection of operational anomalies characterized by tenuous and slow changes in behaviour of the appliance HA (for example, the minimal loss of coolant in a refrigeration circuit, detected by the fact that the periods for which the compressor is active tend to increase very slowly, but progressively, over time), while the device SA would be entrusted with the direct detection of malfunctions characterized by rapid and significant changes in behaviour (for example, the failure of the compressor of a refrigerator, indicated by a excessively long pause in its operation with respect to normal).

The expert system SE could also be entrusted with the detection of appliance malfunctions that would otherwise be difficult the detect.

On this point, it should also be considered that, as time goes by and with the progressive installation of monitoring devices SA, reference patterns relative to a multitude of appliances, also of different types, will be recorded on the expert system SE. On the other hand, reference patterns relative to appliances of the same type, in terms of firm and model, will also be recorded amongst these. The expert system SE could therefore be programmed to also compare the reference patterns relative to homogeneous electrical appliances with each other.

One can consider the case of an electrical appliance that presents a random malfunction in operation right from when it was first installed. Due to the logic of the system, by which the reference patterns are the outcome of readings taken directly by a device SA, the expert system SE could, in theory, consider this behaviour as normal instead of anomalous.

The fact that the expert system SE periodically compares the reference patterns of various homogeneous electrical appliances with each other, therefore allows initial malfunctions of an appliance to be detected as well. In other terms, the fact that the value of a operating parameter of an appliance X deviates significantly with respect to values of the same parameter for an appliance of the same type (or with respect to an average of such values), is indicative of a malfunction on appliance X.

The characteristics of this invention, as well as its advantages, can be clearly seen from the supplied description.

From amongst the other possible variants, the possibility of using an ambient temperature sensor, possibly present on the device SA, for "correction" of the data that the device sends to the centre CR can be mentioned. This is in consideration of the fact that changes in ambient temperature can influence the mode of operation of an appliance (think of a refrigerator), and therefore cause unreliable readings for the electrical quantities measured by the device SA.

According to the proposed variant, also information relative to the ambient temperature is recorded in a non-volatile memory of the device SA, for subsequent transmission from the latter, together with the data relative to the various electrical quantities measured, to the expert system SE.

In another variant, the system can be operative to realize, following a fault on an appliance HA, an association of information on the usage of the appliance to that of the faulty one, via a query on the database of the expert system SE.

Another possibility is that of providing, always at the level of the expert system SE, the construction of a case record of faults on electrical appliance, also in function of the way they are used.

## Claims

1. A method for monitoring electrical appliances, wherein the monitoring of an electrical appliance presenting an electrical load includes the steps of:
a) connecting a monitoring device (SA) to a communications network (RE, RT),
b) measuring, via said monitoring device (SA) and at a point between a source of electric energy (PC) and said electrical appliance (HA), the electric power or current absorbed by said appliance (HA),
**characterized in that**:
c) at least in a learning phase of the method,
c1) the results of measurements of the electric power or current absorbed by said appliance (HA) are transmitted, by said monitoring device (SA) via said communications network (RE, RT), to a remote processing centre (CR, SE),
c2) said remote centre (CR, SE) processes and encodes the result of said measurements for the purposes of obtaining reference data or patterns representative of a theoretical level of absorption of electric power or current that said electrical appliance (HA) would have under normal and correct operating conditions,
c3) said reference data or patterns, as obtained in step c2), are transmitted by said remote centre (CR, SE), over said communication network (RE, RT), to said monitoring device (SA), wherein said reference data or patterns are recorded on memory means (MEM) of said monitoring device (SA),
d) at least in a monitoring phase of the method, following said learning phase in time, said monitoring device (SA) performs the direct execution of the steps of:
d1) comparing the result of measurements of the electric power or current absorbed by said appliance (HA) with the reference data or patterns recorded on said memory means (MEM),
d2) generating, in function of the comparison of step d1), information representative of the operating state of said electrical appliance (HA),
d3) permitting the reading of the information generated in step d2) outside of said device (SA).

2. A method according to claim 1, wherein prior to the transmission of step c1), the data relative to the result of said measurements is recorded on said memory means (MEM) in a compressed format.

3. A method according to claim 1, wherein the processing and encoding operations of step c2) are performed by an expert system (SE), in particular of the inferential engine type using fuzzy logic or implementing a neural network provided with a knowledge base of malfunctions and characteristics of electromechanical components.

4. A method according to claim 1, wherein at the start of said learning phase, the type of electrical appliance (HA) associated with said monitoring device (SA) is communicated to said remote centre (CR, SE).

5. A method according to claim 1, wherein at the start of said learning phase, an identification code for said monitoring device (SA) is communicated to said remote centre (CR, SE), said identification code being in particular linked to the result of said measurements for the purposes of the transmission in step c1)*.*

6. A method according to claim 1, wherein the detection of likely variations in the voltage of the electric power supply that feeds the said appliance (HA) is also provided.

7. A method according to claim 1, wherein periodic transmission of measurements of electric power or current absorbed by said appliance (HA) to said remote centre (CR, SE) is also performed by said monitoring device (SA) during the course of said monitoring phase, for carrying out diagnostic checks on said appliance (HA), said diagnostic checks being in particular dedicated to the detection of operating anomalies that provoke tenuous and slow changes in behaviour of said appliance (HA).

8. A method according to claim 1, **characterized in that** said reference data or patterns, as obtained in step c2), are recorded at said remote centre (CR, SE) and that said remote centre (CR, SE) is operative for comparing reference data or patterns recorded therein with each other, relative to a number of electrical appliances (HA) of the same type, each of said appliances (HA) having a respective said monitoring device (SA).

9. A method according to claim 1, wherein the detection of ambient conditions in which said appliance (HA) works, such as ambient temperature, is also provided, data relative to said detection of ambient conditions being transmitted to said remote centre (CR, SE) during the course of step c1), for the execution of at least one of steps c2) and c3), the data relative to said detection of ambient conditions being in particular recorded in said memory means (MEM).

10. A method according to claim 1, wherein said measurements include at least some of the following:
- measurement of electric current,
- measurement of mains voltage,
- measurement of power factor (cosΦ),
- measurement of absorbed power,
- measurement of electric energy.

11. A method according to claim 1, wherein said information generated by said monitoring device (SA) includes at least some of the following:
- information relative to the operating state of the said appliance (HA),
- statistical information, relative to the operation of said appliance (HA) and to the way in which it is used by the owner or user,
- diagnostic information, relative to the operation of said appliance (HA),
- energy information, relative to the consumption of the said appliance (HA).

12. A method according to claim 1, wherein said expert system (SE) takes care of identifying electromechanical components of said appliance (HA) using clustering techniques, without the need for input of specific data, where in particular said expert system (SE) associates the found clusters to the various electromechanical components present in a family of electrical appliances, exploiting general rules programmed in the same expert system (SE).

13. A method according to claim 8, wherein following a fault on one of said appliances (HA), an association of the information on the usage of the appliance is made to that regarding the fault, via a query on a database of said remote centre (CR), where in particular the construction of a case record of faults on electrical appliances, also in function of their usage, is provided.

14. A system for monitoring electrical appliances presenting an electrical load, the system comprising
- a remote processing centre (CR, SE),
- a communication network (RE, TLI, RT),
- a monitoring device for monitoring (SA) a respective electrical appliance (HA) having an electrical load, said monitoring device (SA) being connected between a source of electric energy (PC) and said electrical appliance (HA), said device (SA) comprising:
- control means (M1),
- measurement means (PM) for detecting the amount of electric power or current absorbed by said appliance (HA),
- interface means (N) for connecting said device (SA) to said communication network (RE, TLI, RT),
- non-volatile memory means (MEM),
said monitoring device (SA) being arranged for measuring the electric power or current absorbed by said appliance (HA),
**characterized in that**
- said monitoring device (SA) is arranged for transmitting to said remote processing centre (CR, SE), via said communications network (RE, RT) and at least in a learning phase of operation of the system, the results of measurements of electric power or current absorbed by said appliance (HA),
- said remote processing centre (CR, SE) is arranged for processing and encoding, at least in said learning phase, the result of said measurements, to obtain reference data or patterns representative of a theoretical level of absorption of electric power or current that said electrical appliance (HA) would have under normal and correct operating conditions,
- said remote processing centre (CR, SE) is also arranged for transmitting to said monitoring device (SA), via said communications network (RE, RT) and at least in said learning phase, said reference data or patterns, said monitoring device (SA) being arranged for recording on said memory means (MEM) the reference data or patterns received by said remote centre (CR, SE),
- said monitoring device (SA) is also arranged for directly executing, at least in a monitoring phase of operation of the system which follows in time said learning phase, the steps of:
i) comparing the result of measurements of the electric power or current absorbed by said appliance (HA) with said reference data or patterns recorded on said memory means (MEM),
ii) generating, in function of the comparison of step i), information representative of the operating state of said electrical appliance (HA),
iii) permitting the reading of the information generated in step ii) outside of said device (SA).

## Patentansprüche

1. Verfahren zur Überwachung von elektrischen Geräten, wobei die Überwachung eines elektrischen Gerätes, welches einen elektrischen Verbraucher darstellt, folgende Schritte beinhaltet:
a) Verbinden eines Überwachungsgerätes (SA) mit einem Kommunikationsnetzwerk (RE, RT),
b) Messen der durch das besagte elektrische Gerät (HA) aufgenommenen elektrischen Leistung oder Stromes mit Hilfe des besagten Überwachungsgerätes (SA) an einer Stelle zwischen einer Elektrizitätsquelle (PC) und dem besagten elektrischen Gerät (HA), **dadurch gekennzeichnet, dass**,
c) zumindest in der Lernphase des Verfahrens,
c1) die Ergebnisse der Messungen der durch das besagte Gerät (HA) aufgenommenen elektrischen Leistung oder Stromes mittels des Überwachungsgerätes (SA) durch das besagte Kommunikationsnetzwerk (RE, RT) zu einer entfernten Zentraleinheit (CR, SE) übertragen werden,
c2) die besagte entfernte Zentraleinheit (CR, SE) das Ergebnis der besagten Messungen verarbeitet und verschlüsselt, um Referenzdaten oder theoretische elektrische Leistungs- oder Stromaufnahmemuster typisch für das besagte elektrische Gerät (HA) unter normalen und ordnungsgemäßen Betriebsbedingungen zu gewinnen,
c3) die in Schritt c2) gewonnenen Referenzdaten oder Muster mittels der besagten entfernten Zentraleinheit (CR, SE) über das besagte Kommunikationsnetzwerk (RE, RT) zu dem besagten Überwachungsgerät (SA) übertragen werden, wobei die besagten Referenzdaten oder Muster auf einem Speichermedium (MEM) des besagten Überwachungsgerätes (SA) gespeichert werden,
d) zumindest in der besagter Lernphase darauffolgenden Überwachungsphase des Verfahrens, das besagte Überwachungsgerät (SA) folgende Schritte unmittelbar ausführt:
d1) Abgleichen des Ergebnisses der Messungen der durch das besagte Gerät (HA) aufgenommenen elektrischen Leistung oder Stromes mit den auf besagtem Speichermedium (MEM) gespeicherten Referenzdaten oder Muster,
d2) Erzeugen von aussagekräftigen Informationen hinsichtlich des Betriebszustandes des besagten elektrischen Gerätes (HA) in Abhängigkeit des in Schritt d1) ausgeführten Abgleichs,
d3) Ermöglichen einer Ablesung der in Schritt d2) erzeugten Informationen außerhalb des besagten Überwachungsgerätes (SA).

2. Verfahren nach Anspruch 1, **dadurch gekennzeichnet, dass** vor der Übertragung in Schritt c1) die Daten in Abhängigkeit vom Ergebnis der besagten Messungen auf besagtem Speichermedium (MEM) in einem komprimierten Format gespeichert werden.

3. Verfahren nach Anspruch 1, **dadurch gekennzeichnet, dass** die Verarbeitungs- und Verschlüsselungsabläufe in Schritt c2) von einem Expertensystem (SE) ausgeführt werden, insbesondere von einer Schlussfolgerungen ziehenden Funktionseinheit, welche Fuzzy-Logik einsetzt oder ein mit einer Wissensdatenbank über Fehlfunktionen und Eigenschaften von elektromechanischen Komponenten ausgestattetes, neurales Netzwerk zur Anwendung bringt.

4. Verfahren nach Anspruch 1, **dadurch gekennzeichnet, dass** zu Beginn der besagten Lernphase die Art des mit besagtem Überwachungsgerät (SA) verbundenen elektrischen Gerätes (HA) der entfernten Zentraleinheit (CR, SE) übermittelt wird.

5. Verfahren nach Anspruch 1, **dadurch gekennzeichnet, dass** zu Beginn der besagten Lernphase eine Kennung für besagtes Überwachungsgerät (SA) an die besagte entfernte Zentraleinheit (CR, SE) übermittelt wird, wobei die Kennung insbesondere mit dem Ergebnis der besagten Messungen zum Zweck der Übertragung in Schritt c1) verknüpft ist.

6. Verfahren nach Anspruch 1, **dadurch gekennzeichnet, dass** eine Detektion von wahrscheinlichen Spannungsschwankungen des Netzgerätes, welches besagtes elektrisches Gerät (HA) versorgt, ebenfalls vorgesehen ist.

7. Verfahren nach Anspruch 1, **dadurch gekennzeichnet, dass** eine in gleichen Zeitabständen wiederkehrende Übertragung der Messungen der durch das besagte Gerät (HA) aufgenommenen elektrischen Leistung oder Stromes zu der besagten entfernten Zentraleinheit (CR, SE) mittels des Überwachungsgerätes (SA) auch während der Überwachungsphase ausgeführt wird, wobei die besagten Diagnoseläufe insbesondere zur Detektion von Funktionsstörungen dienen, welche schwache und langsame Änderungen im Verhalten des besagten elektrischen Gerätes (HA) hervorrufen.

8. Verfahren nach Anspruch 1, **dadurch gekennzeichnet, dass** die in Schritt c2) gewonnenen, besagten Referenzdaten oder Muster in der besagten entfernten Zentraleinheit (CR, SE) gespeichert werden und dass die besagte entfernte Zentraleinheit (CR, SE) für den gegenseitigen Abgleich der in derselben gespeicherten Referenzdaten oder Muster bezüglich einer Anzahl an gleichartigen elektrischen Geräten (HA) eingesetzt wird, wobei jedes der besagten elektrischen Geräte (HA) ein entsprechendes Überwachungsgerät (SA) aufweist.

9. Verfahren nach Anspruch 1, **dadurch gekennzeichnet, dass** eine Detektion der Umgebungsbedingungen, in denen das besagte elektrische Gerät (HA) arbeitet, wie beispielsweise die Umgebungstemperatur, ebenfalls vorgesehen ist, wobei die Daten in Abhängigkeit der besagten Detektion der Umgebungsbedingungen während Schritt c1) und für die Ausführung von mindestens einem der Schritte c2) und c3) zur besagten entfernten Zentraleinheit (CR, SE) übertragen werden, wobei die Daten in Abhängigkeit der besagten Detektion der Umgebungsbedingungen insbesondere auf besagtem Speichermedium (MEM) gespeichert werden.

10. Verfahren nach Anspruch 1, **dadurch gekennzeichnet, dass** besagte Messungen mindestens einige der nachfolgend aufgeführten Messungen beinhalten:
- Messung des elektrischen Stromes,
- Messung der Netzspannung,
- Messung des Leistungsfaktors (cosΦ),
- Messung der aufgenommenen Leistung,
- Messung der elektrischen Energie.

11. Verfahren nach Anspruch 1, **dadurch gekennzeichnet, dass** die durch das besagte Überwachungsgerät (SA) erzeugten Informationen mindestens einige der nachfolgend aufgeführten Informationen beinhalten:
- Informationen bezüglich des Betriebszustandes des besagten elektrischen Gerätes (HA),
- Statistische Informationen bezüglich des Betriebs des besagten elektrischen Gerätes (HA) und bezüglich der Art der Nutzung desselbigen durch den Besitzer oder Benutzer,
- Diagnostische Informationen bezüglich des Betriebs des besagten elektrischen Gerätes (HA),
- Energetische Informationen bezüglich des Verbrauchs des besagten elektrischen Gerätes (HA).

12. Verfahren nach Anspruch 1, **dadurch gekennzeichnet, dass** besagtes Expertensystem (SE) die Identifizierung der elektromechanischen Komponenten des besagten elektrischen Gerätes (HA) mittels Gruppierungsmethoden ohne die Notwendigkeit zur Eingabe von konkreten Daten übernimmt, wobei insbesondere das besagte Expertensystem (SE) die gefundenen Gruppen mit den verschiedenen elektromechanischen, der Kategorie der elektrischen Geräte zugehörigen Komponenten unter Ausnutzung von allgemeinen, im selben Expertensystem (SE) programmierten Regeln verknüpft.

13. Verfahren nach Anspruch 8, **dadurch gekennzeichnet, dass** eine auf einen Fehler bei einem der besagten elektrischen Geräte (HA) folgende Verknüpfung der Information über den Einsatz des Gerätes mit der den Fehler betreffenden Information mittels einer Datenbankabfrage bei der besagten entfernten Zentraleinheit (CR) erstellt wird, wobei insbesondere die Erstellung einer Akte über Fehler bei elektrischen Geräten, auch in Abhängigkeit von deren Nutzung, vorgesehen ist.

14. Anordnung zur Überwachung von elektrischen Geräten, welche einen elektrischen Verbraucher darstellen, aufweisend
- eine entfernte Zentraleinheit (CR, SE),
- ein Kommunikationsnetzwerk (RE, TLI, RT),
- ein Überwachungsgerät (SA) zur Überwachung eines entsprechenden elektrischen Gerätes (HA), welches einen elektrischen Verbraucher darstellt, wobei das besagte, zwischen der Elektrizitätsquelle (PC) und dem besagten elektrischen Gerät (HA) angeschlossene Überwachungsgerät (SA), aufweisend:
- Kontrollmittel (M1),
- Messmittel (PM) zum Detektieren des Betrages der von besagtem elektrischen Gerät (HA) aufgenommenen elektrischen Leistung oder Stromes,
- Schnittstellenmittel (N) zum Verbinden des besagten Überwachungsgerätes (SA) mit dem besagten Kommunikationsnetzwerkes (RE, TLI, RT),
- Speichermittel (MEM) zum dauerhaften Speichern,
zum Messen der durch das besagte elektrische Gerät (HA) aufgenommenen elektrischen Leistung oder Stromes angeordnet ist, **dadurch gekennzeichnet, dass**
- das besagte Überwachungsgerät (SA) zu der besagten entfernten Zentraleinheit (CR, SE) durch das besagte Kommunikationsnetzwerk (RE, RT) übertragend und, zumindest in einer Lernphase des Betriebes der Anordnung, die Ergebnisse der Messungen der durch besagtes elektrisches Gerät (HA) aufgenommenen elektrischen Leistung oder Stromes übertragend ausgestaltet ist,
- die besagte entfernte Zentraleinheit (CR, SE), zumindest während besagter Lernphase, zum Verarbeiten und Verschlüsseln der besagten Messungen ausgestaltet ist, um Referenzdaten oder theoretische elektrische Leistungs- oder Stromaufnahmemuster typisch für das besagte elektrische Gerät (HA) unter normalen und ordnungsgemäßen Betriebsbedingungen zu gewinnen,
- die besagte entfernte Zentraleinheit (CR, SE) ebenfalls zu dem besagten Überwachungsgerät (SA) durch das besagte Kommunikationsnetzwerk (RE, RT) übertragend und, zumindest in der besagten Lernphase, besagte Referenzdaten oder Muster übertragend ausgestaltet ist, wobei das besagte Überwachungsgerät (SA) die von besagter entfernter Zentraleinheit (CR, SE) empfangenen Referenzdaten oder Muster auf besagtes Speichermedium (MEM) speichernd ausgestaltet ist,
- das besagte Überwachungsgerät (SA) auch, zumindest in der besagter Lernphase darauffolgenden Überwachungsphase des Betriebes der Anordnung, folgende Schritte unmittelbar ausführend ausgestaltet ist:
i) Abgleichen des Ergebnisses der Messungen der durch das besagte Gerät (HA) aufgenommenen elektrischen Leistung oder Stromes mit den auf besagtem Speichermedium (MEM) gespeicherten Referenzdaten oder Muster,
ii) Erzeugen von aussagekräftigen Informationen hinsichtlich des Betriebszustandes des besagten elektrischen Gerätes (HA) in Abhängigkeit des in Schritt i) ausgeführten Abgleichs,
iii) Ermöglichen einer Ablesung der in Schritt ii) erzeugten Informationen außerhalb des besagten Überwachungsgerätes (SA).

## Revendications

1. Procédé de surveillance d'appareils électriques, dans lequel la surveillance d'un appareil électrique présentant une charge électrique comprend les étapes consistant à :
a) connecter un dispositif de surveillance (SA) à un réseau de communications (RE, RT),
b) mesurer, par l'intermédiaire dudit dispositif de surveillance (SA) et au niveau d'un point situé entre une source d'énergie électrique (PC) et ledit appareil électrique (HA), la puissance électrique ou le courant électrique absorbé(e) par ledit appareil (HA),
**caractérisé en ce que** :
c) au moins durant une phase d'apprentissage du procédé,
c1) les résultats des mesures de la puissance électrique ou du courant électrique absorbé(e) par ledit appareil (HA) sont transmis, par ledit dispositif de surveillance (SA) par l'intermédiaire dudit réseau de communications (RE, RT), à un centre de traitement éloigné (CR, SE),
c2) ledit centre éloigné (CR, SE) traite et code le résultat desdites mesures dans le but d'obtenir des données de référence ou des configurations de référence représentatives d'un niveau théorique d'absorption de la puissance électrique ou du courant électrique que ledit appareil électrique (HA) aurait dans des conditions de fonctionnement normales et correctes,
c3) lesdites données de référence ou lesdites configurations de référence, telles qu'obtenues à l'étape c2), sont transmises par ledit centre éloigné (CR, SE) sur ledit réseau de communications (RE, RT) au dit dispositif de surveillance (SA), dans lequel lesdites données de référence ou lesdites configurations de référence sont enregistrées sur des moyens de mémoire (MEM) dudit dispositif de surveillance (SA),
d) au moins, dans une phase de surveillance du procédé, après la phase d'apprentissage dans le temps, ledit dispositif de surveillance (SA) effectue l'exécution directe des étapes consistant à :
d1) comparer le résultat des mesures de la puissance électrique ou du courant électrique absorbé(e) par ledit appareil (HA) avec les données de référence ou les configurations de référence enregistrées sur lesdits moyens de mémoire (MEM),
d2) générer, en fonction de la comparaison réalisée à l'étape d1), une information représentative de l'état de fonctionnement dudit appareil électrique (HA),
d3) permettre la lecture de l'information générée à l'étape d2) à l'extérieur dudit dispositif (HA) .

2. Procédé selon la revendication 1, dans lequel, avant la transmission de l'étape c1), les données relatives au résultat desdites mesures sont enregistrées sur lesdits moyens de mémoire (MEM) dans un format compressé.

3. Procédé selon la revendication 1, dans lequel les opérations de traitement et de codage de l'étape c2) sont effectuées par un système expert (SE), en particulier du type à moteur d'inférences en utilisant une logique floue ou en mettant en oeuvre un réseau neuronal fourni avec une base de connaissances des dysfonctionnements et des caractéristiques des composants électromécaniques.

4. Procédé selon la revendication 1, dans lequel au démarrage de ladite phase d'apprentissage, le type de l'appareil électrique (HA) associé au dit dispositif de surveillance (SA) est communiqué au dit centre éloigné (CR, SE).

5. Procédé selon la revendication 1, dans lequel au démarrage de ladite phase d'apprentissage, un code d'identification destiné au dit dispositif de surveillance (SA) est communiqué au dit centre éloigné (CR, SE), ledit code d'identification étant lié, en particulier, au résultat desdites mesures, à des fins de transmission dans l'étape c1).

6. Procédé selon la revendication 1, dans lequel la détection des variations probables dans la tension de l'alimentation électrique qui alimente ledit appareil (HA) est également prévue.

7. Procédé selon la revendication 1, dans lequel une transmission périodique des mesures de la puissance électrique ou du courant électrique absorbé(e) par ledit appareil (HA) au dit centre éloigné (CR, SE) est également exécutée par ledit dispositif de surveillance (SA) au cours de ladite phase de surveillance, en vue de réaliser des contrôles de diagnostic sur ledit appareil (HA), lesdits contrôles de diagnostic étant spécialement dédiés à la détection des anomalies de fonctionnement qui provoquent de faibles et lentes variations dans le comportement dudit appareil (HA).

8. Procédé selon la revendication 1, **caractérisé en ce que** lesdites données de référence ou configurations de référence, telles qu'obtenues à l'étape c2), sont enregistrées au niveau dudit centre éloigné (CR, SE) et **en ce que** ledit centre éloigné (CR, SE) est opérationnel pour comparer les unes avec les autres les données ou les configurations de référence qui y sont enregistrées, par rapport à un certain nombre d'appareils électriques (HA) du même type, chacun desdits appareils (HA) comportant un dit dispositif de surveillance respectif (SA).

9. Procédé selon la revendication 1, dans lequel la détection des conditions ambiantes dans lesquelles ledit appareil (HA) fonctionne, telles que la température ambiante, est également fournie, les données relatives à ladite détection des conditions ambiantes étant transmises au dit centre éloigné (CR, SE) au cours de l'étape c1), en vue de l'exécution d'au moins l'une des étapes c2) et c3), les données concernant ladite détection des conditions ambiantes étant enregistrées, en particulier, dans lesdits moyens de mémoire (MEM).

10. Procédé selon la revendication 1, dans lequel lesdites mesures incluent au moins quelques unes des mesures suivantes :
- mesure du courant électrique,
- mesure de la tension principale,
- mesure du facteur de puissance (cosΦ),
- mesure de la puissance absorbée,
- mesure de l'énergie électrique.

11. Procédé selon la revendication 1, dans lequel ladite information générée par ledit dispositif de surveillance (SA) comprend au moins quelques unes des informations suivantes :
- information relative à l'état de fonctionnement dudit appareil (HA),
- information statistique, relative au fonctionnement dudit appareil (HA) et à la façon suivant laquelle il est utilisé par son propriétaire ou son utilisateur,
- information de diagnostic relative au fonctionnement dudit appareil (HA),
- information sur l'énergie relative à la consommation dudit appareil (HA).

12. Procédé selon la revendication 1, dans lequel ledit système expert (SE) prend soin d'identifier les composants électromécaniques dudit appareil (HA) en utilisant des techniques de regroupement sans avoir besoin d'introduire des données spécifiques, dans lequel, en particulier, ledit système expert (SE) associe les groupes trouvés aux divers composants électromécaniques présents dans une famille d'appareils électriques, en exploitant des règles générales programmées dans le même système expert (SE).

13. Procédé selon la revendication 8, dans lequel à la suite d'une défaillance constatée sur l'un desdits appareils (HA), une association de l'information sur l'utilisation de l'appareil est effectuée en ce qui concerne la défaillance , par l'intermédiaire d'une requête sur une base de données dudit centre éloigné (CR), dans lequel , en particulier, la construction d'un enregistrement de cas de défaillances sur des appareils électriques, également en fonction de leur utilisation, est fournie.

14. Système pour surveiller des appareils électriques présentant une charge électrique, le système comportant :
- un centre de traitement éloigné (CR, SE),
- un réseau de communications (RE, TLI, RT),
- un dispositif de surveillance permettant de surveiller (SA) un appareil électrique respectif (HA) présentant une charge électrique, ledit dispositif de surveillance (SA) étant connecté entre une source d'énergie électrique (PC) et ledit appareil électrique (HA), ledit dispositif (SA) comprenant :
- des moyens de commande (M1),
- des moyens de mesure (PM) permettant de détecter la quantité de puissance électrique ou de courant électrique absorbé(e) par ledit appareil (HA),
- des moyens d'interface (N) pour connecter ledit dispositif (SA) au dit réseau de communications (RE, TLI, RT),
- des moyens de mémoire non volatile (MEM),
ledit dispositif de surveillance (SA) étant agencé pour mesurer la puissance électrique ou le courant électrique absorbé(e) par ledit appareil (HA),
**caractérisé en ce que**
- ledit dispositif de surveillance (SA) est agencé en vue de transmettre au dit centre de traitement éloigné (CR, SE), par l'intermédiaire dudit réseau de communications (RE, RT), et au moins durant une phase d'apprentissage du fonctionnement du système, les résultats des mesures de la puissance électrique ou du courant électrique absorbé(e) par ledit appareil (HA),
- ledit centre de traitement à distance (CR, SE) est agencé pour traiter et coder, au moins durant ladite phase d'apprentissage, le résultat desdites mesures afin d'obtenir des données ou des configurations de référence représentatives d'un niveau théorique d'absorption de la puissance électrique ou du courant électrique que ledit appareil électrique (HA) devrait avoir dans des conditions de fonctionnement normales et correctes,
- ledit centre de traitement à distance (CR, SE) est également agencé pour transmettre au dit dispositif de surveillance (SA), par l'intermédiaire dudit réseau de communications (RE, RT), et au moins durant ladite phase d'apprentissage, lesdites données ou configurations de référence, ledit dispositif de surveillance (SA) étant agencé en vue d'enregistrer sur lesdits moyens de mémoire (MEM) les données ou les configurations de référence reçues par ledit centre éloigné (CR, SE),
- ledit dispositif de surveillance (SA) est également agencé pour exécuter directement, au moins durant une phase de surveillance du fonctionnement du système qui suit dans le temps ladite phase d'apprentissage, les étapes consistant à :
i) comparer le résultat des mesures de la puissance électrique ou du courant électrique absorbé(e) par ledit appareil (HA) avec lesdites données ou lesdites configurations de référence enregistrées sur lesdits moyens de mémoire (MEM),
ii) générer, en fonction de la comparaison opérée dans l'étape i), une information représentative de l'état de fonctionnement dudit appareil électrique (HA),
iii) permettre la lecture de l'information générée dans l'étape ii) à l'extérieur dudit dispositif (SA).
